Europäisches Patentamt

European Patent Office

Office européen des brevets

(11) Numéro de publication: **0 013 191**
**A1**

## (12) DEMANDE DE BREVET EUROPEEN

(21) Numéro de dépôt: **79400842.5**

(22) Date de dépôt: **09.11.79**

(51) Int. Cl.³: **G 06 K 19/06**
**G 11 C 19/08**

(30) Priorité: **21.12.78 FR 7836048**

(43) Date de publication de la demande:
**09.07.80 Bulletin 80/14**

(84) Etats Contractants Désignés:
**DE GB IT**

(71) Demandeur: **COMPAGNIE INTERNATIONALE POUR L'INFORMATIQUE CII-HONEYWELL BULL (dite CII-HB)**
**94, avenue Gambetta**
**F-75020 Paris(FR)**

(72) Inventeur: **Lazzari, Jean-Pierre**
**29, rue André Thomas**
**F-78490 Monfort L'Amaury(FR)**

(74) Mandataire: **Gouesmel, Daniel**
**94, avenue Gambetta**
**F-75020 Paris(FR)**

(54) **Carte portative comportant des éléments à bulles magnétiques.**

(57) Carte portative comprenant des moyens de traitement de l'information (6,8,10,20).

Selon l'invention, au moins une partie (6) de ces moyens est constitué par des éléments à bulles magnétiques.

Applicable aux cartes de crédit, d'identification etc...

FIG.1

Croydon Printing Company Ltd.

1

## CARTE PORTATIVE COMPORTANT DES ELEMENTS
## A BULLES MAGNETIQUES

La présente invention a pour objet une carte portative servant de support à des informations. Il peut s'agir par exemple d'une carte de crédit utilisable dans le secteur commercial et bancaire, ou d'une carte d'identification employée dans des systèmes de contrôle ou de sécurité par exemple.

Bien qu'un tel support puisse prendre des formes extrêmement variées (carte proprement dite, bague, clé, ticket, fiche, etc...), on utilisera par la suite, et pour simplifier, le terme "carte", (qui correspond d'ailleurs au cas le plus fréquent), sans que cela implique naturellement une quelconque limitation de l'invention.

Les systèmes à cartes portatives sont de plus en plus utilisés aujourd'hui. Il s'agit d'un ensemble de moyens de traitement de l'information qui comprend une pluralité de cartes individuelles et au moins un poste de commande collectif qui est en général fixe. Chaque carte comprend essentiellement des moyens de traitement de l'information et au moins une mémoire dans laquelle est enregistré un code confidentiel d'identification qui n'est connu que du titulaire légitime de la carte. Les postes de commande comprennent eux aussi des moyens de traitement de
l'information et des moyens de commande manuelle constituée le plus souvent par un clavier. A l'aide d'un tel
système, le titulaire d'une carte peut procéder à certaines opérations financières ou comptables dont les plus
fréquentes sont la distribution de billets de banque et
la tenue d'un compte. Pour cela, il lui suffit d'introduire sa carte dans un poste de commande, puis de définir
les opérations souhaitées à l'aide du clavier. Ces opérations ne peuvent être effectuées qu'à la condition que
l'utilisateur de la carte soit en mesure de fournir le
code confidentiel correspondant à la carte utilisée. Cette
opération de contrôle préalable permet d'éviter les fraudes en cas de perte ou de vol de la carte.

Un système de ce genre doit donc comprendre un organe
apte à comparer le code mémorisé dans la carte et le code transmis de l'extérieur par l'utilisateur de la carte.
Cet organe comparateur pourrait être situé dans le poste
de commande, mais il est préférable de le disposer à l'intérieur de la carte, afin d'éviter d'avoir à transférer
le code d'identification à l'extérieur pour y être comparé au code indiqué, ce qui affaiblirait le caractère
d'inviolabilité du système.

On connaît des cartes portatives dont le support d'informations est constitué par une ou plusieurs pistes magnétiques. Il s'agit par exemple des cartes dites "cartes
bleues". Les informations y sont traduites par des aimantations que présentent une pluralité de zones magnétiques. La lecture de ces informations et éventuellement
l'écriture de nouvelles informations, s'effectuent en
général lors du mouvement du support devant des têtes magnétiques de lecture et d'écriture.

3

A propos de ce type de cartes, on pourra se reporter par exemple au brevet français n° 1 114 901 délivré le 26 décembre 1955 et intitulé "Machines comptables".

Les cartes à piste magnétique présentent de nombreux inconvénients. Elles offrent tout d'abord une faible capacité de mémorisation. Elles présentent ensuite des risques de perte de l'information enregistrée, notamment sous l'action de champs magnétiques parasites ou sous l'effet d'une chaleur excessive. Enfin et surtout, elles ne satisfont pas à la condition d'inviolabilité évoquée plus haut, car il est possible, pour un spécialiste, de faire apparaître le code confidentiel contenu sur la piste magnétique et d'utiliser ensuite la carte à son profit de manière illégitime.

On a donc tenté de réaliser des cartes portatives à support d'information non magnétique, qui offrent une plus grande capacité et qui rendent beaucoup plus difficile la violation du secret du code. A cette fin, il a été proposé des cartes "électroniques". Il s'agit de cartes dans lesquelles la mémorisation du code s'effectue au moyen de circuits électroniques à semiconducteurs. De telles cartes utilisent par exemple des mémoires mortes programmables (désignées, en terminologie anglosaxonne, par "Programmable Read Only Memories" ou, en abrégé, "PROM").

On pourra consulter, à ce sujet, deux brevets français, le premier qui porte le numéro 2 139 258 et qui a été délivré le 11 décembre 1972 sous le titre "Cartes d'informations" et qui décrit une carte comprenant une mémoire constituée d'une matrice de diodes semiconductrices, et le second qui porte le numéro 2 180 349 et qui a été délivré le 29 octobre 1973 sous le titre "Dispositif d'i-

4

dentification individuelle de plusieurs personnes", et qui décrit une carte utilisant une mémoire réalisée en circuits intégrés du type métal-oxyde-semiconducteur (en abrégé MOS).

On pourra consulter également des demandes de brevet français plus récentes et notamment la demande n° 74 10191 déposée le 25 mars 1974 sous le titre "Procédé et dispositif de commande électronique" ainsi que la demande n° 75 14807 déposée le 13 mai 1975 sous le titre "Système pour transférer et mémoriser des données de manière personnelle et confidentielle au moyen d'objets portatifs électroniques indépendants". Ces deux demandes décrivent des cartes dans lesquelles le support de mémorisation des informations est constitué par un circuit monolithique à semiconducteurs, réalisé selon la technique des circuits intégrés.

Le remplacement des supports magnétiques par des dispositifs électroniques à semiconducteurs a semblé avantageux pour des raisons qui sont clairement exposées dans la dernière demande de brevet citée, où il est indiqué page 5 "Ces mémoires mortes monolithiques du type à semiconducteurs présentent par rapport aux autres mémoires mortes telles que cassettes magnétiques, disques souples, etc... des avantages appréciables. En effet, elles sont plus fiables ; leurs dimensions sont plus petites ; elles ne nécessitent pas de mouvements mécaniques pour la lecture de l'écriture ; elles sont insensibles aux champs magnétiques ; elles sont difficiles à contrefaire et à violer (le fraudeur doit mettre en oeuvre des moyens électroniques complexes pour modifier l'état d'une mémoire morte du type à semiconducteurs)".

5

Si ces dispositifs électroniques ont donné satisfaction à certains égards, ils présentent néanmoins encore deux inconvénients ;

- la détection du code confidentiel d'identification est certes difficile, mais elle est nullement impossible à un spécialiste en électronique.

- les mémoires à semiconducteurs sont des mémoires "mortes" qui ne permettent qu'une opération de lecture.

La présente invention a justement pour objet un type de carte portative qui ne présente pas ces deux inconvénients car, d'une part, cette carte est pratiquement inviolable, et, d'autre part, elle contient une mémoire "vive", ce qui lui confère une grande souplesse de mise en oeuvre.

Ce double but est atteint par l'invention grâce à l'utilisation d'éléments à bulles magnétiques. Pour bien comprendre cette caractéristique de l'invention, il est utile de rappeler brièvement en quoi consiste ce type d'élément.

Dans une couche magnétique monocristalline présentant une anisotropie magnétique uniaxiale perpendiculaire au plan de la couche (on utilise généralement des orthoferrites ou certains grenats) il est possible de créer des domaines magnétiques, en général cylindriques, dans lesquels l'induction magnétique possède un sens opposé à celui qu'elle présente dans le reste de la couche. Ces domaines, appelés traditionnellement "bulles", peuvent être déplacés dans la couche. Pour cela, la couche est revêtue d'un réseau de bandes métalliques aimantables formant un chemin de guidage et elle est soumise à un champ magnétique

0013191

6

tournant appliqué dans le plan de la couche.

Les bulles magnétiques peuvent être déplacées jusqu'à un organe de détection ; mais elles peuvent être aussi immobilisées dans la couche. Pour assurer la stabilité des bulles dans le temps, il est nécessaire d'appliquer à la couche un champ magnétique continu, dit champ de polarisation ou de stabilisation, lequel doit être perpendiculaire à la couche.

On peut réaliser ainsi des circuits logiques, des comparateurs, des mémoires, etc... A propos de cette dernière catégorie d'élément, on pourra se reporter au brevet américain n° 2 919 432 délivré le 29 décembre 1959 et intitulé "Magnetic Device".

L'utilisation d'éléments de caractère magnétique dans une carte portative va à l'encontre des préjugés de l'art antérieur, comme en témoigne l'argumentation citée plus haut, avancée par les partisans de la solution électronique. Contre toute attente, ce moyen confère auxdites cartes des performances très supérieures à celles des cartes électroniques, notamment en ce qui concerne l'inviolabilité du code d'identification, comme on le comprendra mieux par la suite.

De façon plus précise, la présente invention a donc pour objet une carte portative, comprenant des moyens de traitement de l'information, caractérisée en ce qu'au moins une partie de ces moyens est constituée par des éléments à bulles magnétiques.

De préférence, l'un au moins des éléments à bulles magnétiques est une mémoire.

7

De préférence encore, l'ensemble des éléments à bulles
magnétiques comprend une couche de matériau magnétique
apte à contenir des bulles magnétiques, cette couche
étant munie d'un chemin de propagation et d'un moyen
de détection des bulles, et des moyens de création d'un
champ magnétique de polarisation perpendiculaire à ladite couche.

De toute façon, les caractéristiques et avantages de l'invention apparaîtront mieux après la description qui suit,
d'exemples de réalisation donnés à titre explicatif et
nullement limitatif. Cette description se réfère à des
dessins sur lesquels :
- la figure 1 représente un schéma synoptique des moyens
constituant une carte portative,
- la figure 2 est une coupe transversale en vue éclatée
d'une carte portative munie, selon l'invention, d'éléments à bulles,
- la figure 3 montre un exemple de réalisation de moyens
de propagation et de détection des bulles magnétiques.

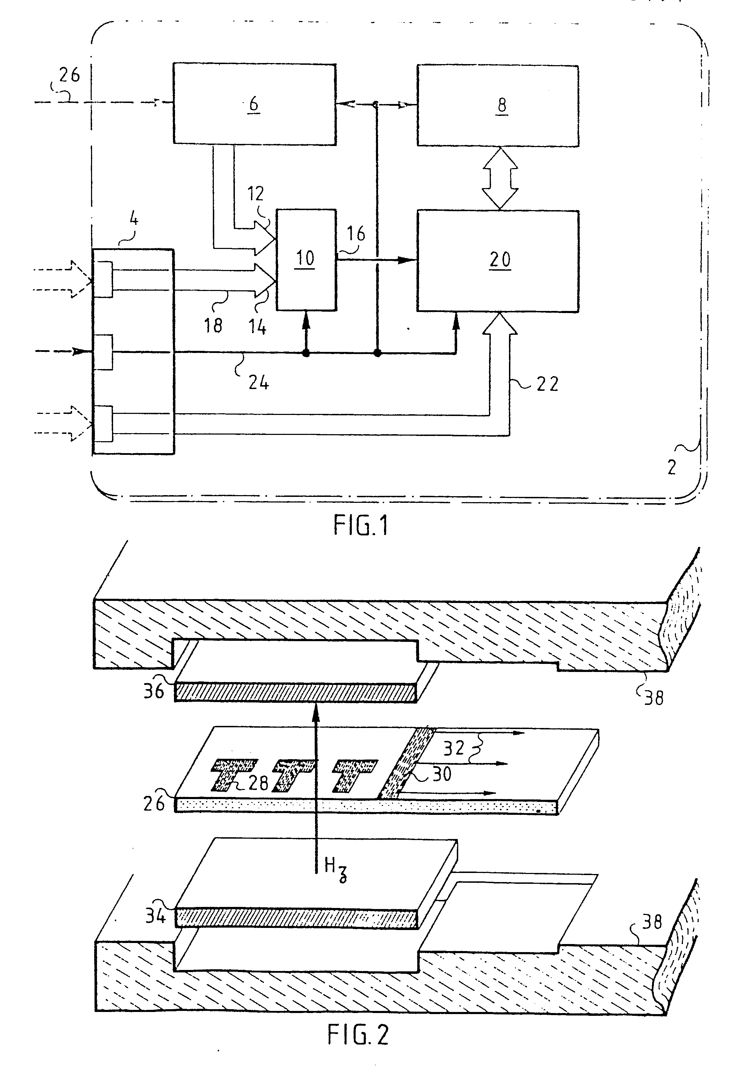

Le schéma synoptique représenté sur la figure 1 correspond aussi bien aux cartes portatives conformes à
l'invention qu'aux cartes selon l'art antérieur. La
carte représentée comprend un support isolant 2, de
forme rectangulaire, sur lequel sont disposés un coupleur d'interface 4, une première mémoire 6 dont le
rôle est de contenir le code confidentiel d'identification de la carte, une seconde mémoire 8 pour la
mémorisation d'informations diverses, un comparateur
10 à deux entrées 12 et 14 et une sortie 16. L'entrée 12 du comparateur est reliée à la mémoire 6 et

8

l'entrée 14 reçoit un bus 18 aboutissant au coupleur d'interface 4 ; la sortie 16 est reliée à un circuit 20 de traitement de données qui reçoit un bus 22 aboutissant lui aussi au coupleur d'interface 4. Enfin, une connexion 24 est prévue pour l'alimentation des mémoires 6 et 8, du comparateur 10 et du circuit 20.

Le fonctionnement de cet ensemble est le suivant. Lors de la première mise en service de la carte, un code d'identification est écrit dans la mémoire 6 par une connexion d'écriture 26 (représentée en tirets) qui est ensuite supprimée. Ce code devient alors inaccessible de l'extérieur de la carte. Pour utiliser sa carte, le titulaire l'introduit dans un poste de traitement qui est conçu pour pouvoir commander certaines opérations, notamment financières ou comptables, mais qui, en premier lieu, doit recevoir le code d'identification de la part de l'utilisateur. Ce code est introduit dans le poste de commande, par exemple au moyen d'un clavier à touches, puis véhiculé vers la carte portative par le coupleur d'interface 4 et le bus 18. Le comparateur 10 reçoit le code fourni par l'opérateur sur son entrée 14 et le code inscrit dans la mémoire 6 sur son entrée 12. En cas d'identité de ces deux codes, mais seulement en cas d'identité, le comparateur 10 délivre sur sa sortie 16 un signal d'autorisation qui est transmis au circuit de traitement 20. Celui-ci peut alors traiter les instructions et les données qu'il reçoit par le bus 22. La mémoire auxiliaire 8 est utilisée pour stocker le résultat des opérations effectuées.

La structure et le fonctionnement détaillés des circuits mis en oeuvre dans une telle carte ne sont pas donnés ici car ils sont connus de l'homme de l'art et déjà largement décrits dans les documents cités plus haut, qui doivent

9

être considérés comme incorporés à la présente description.

Selon l'invention, une partie au moins des moyens de
traitement de l'information est constituée par un élément à bulles magnétiques. A titre d'exemple, la figure
2 représente schématiquement une coupe en vue éclatée
d'une carte dans laquelle cet élément est la mémoire 6
chargée de contenir le code d'identification.

Les moyens représentés sur cette figure comprennent une
couche 26 d'un matériau magnétique apte à contenir des
bulles magnétiques (orthoferrite ou grenat, par exemple
grenat d'yttrium) ladite couche étant recouverte d'un
chemin de propagation 28, et pourvue de moyens de génération, de détection, et d'annihilation de bulles magnétiques, ces moyens étant symboliquement représentés par
l'élément 30 duquel partent des connexions 32. La couche
magnétique 26 est insérée entre deux aimants plats 34 et
36 qui créent, perpendiculairement au plan de la couche
26, un champ magnétique continu de polarisation Hz apte
à assurer la stabilité des bulles dans la couche 26. L'ensemble est encastré et éventuellement collé, dans un support de protection 38 qui permet la manipulation de la
carte sans risque de destruction de l'information.

Les informations mémorisées de cette manière dans la couche magnétique 26 sont inviolables. En effet, le seul
moyen de mettre en évidence les domaines magnétiques présents dans cette couche serait d'effectuer une analyse
de cette couche au moyen d'un appareil apte à détecter
l'orientation de l'induction magnétique, par exemple, un
appareil basé sur l'effet Kerr. Mais cette analyse supposerait que l'on ait au préalable enlevé les deux aimants permanents 34 et 36, ce qui supprimerait le champ de polarisation et provoquerait la destruction des bulles.

Ainsi, toute tentative d'analyse physique de la couche
26 entraîne-t-elle la destruction des informations qu'elle
contient. Cet avantage de l'élément à bulles est unique,
car, avec les éléments électroniques, il est toujours possible, avec des moyens d'analyse perfectionnés, d'en déterminer le contenu sans détruire les informations recherchées.

Une grande variété de moyens est disponible pour équiper
les éléments à bulles de la carte de l'invention. On pourra consulter à ce sujet, par exemple le brevet français
71/31084 déposé le 20 août 1971, la demande de certificat
d'addition à ce brevet n° 71/35367 déposée le 28 septembre 1971, la demande de brevet français n° 72/44640 déposée le 4 décembre 1972 et enfin la demande de brevet
français 75/26029 déposée le 22 août 1975.

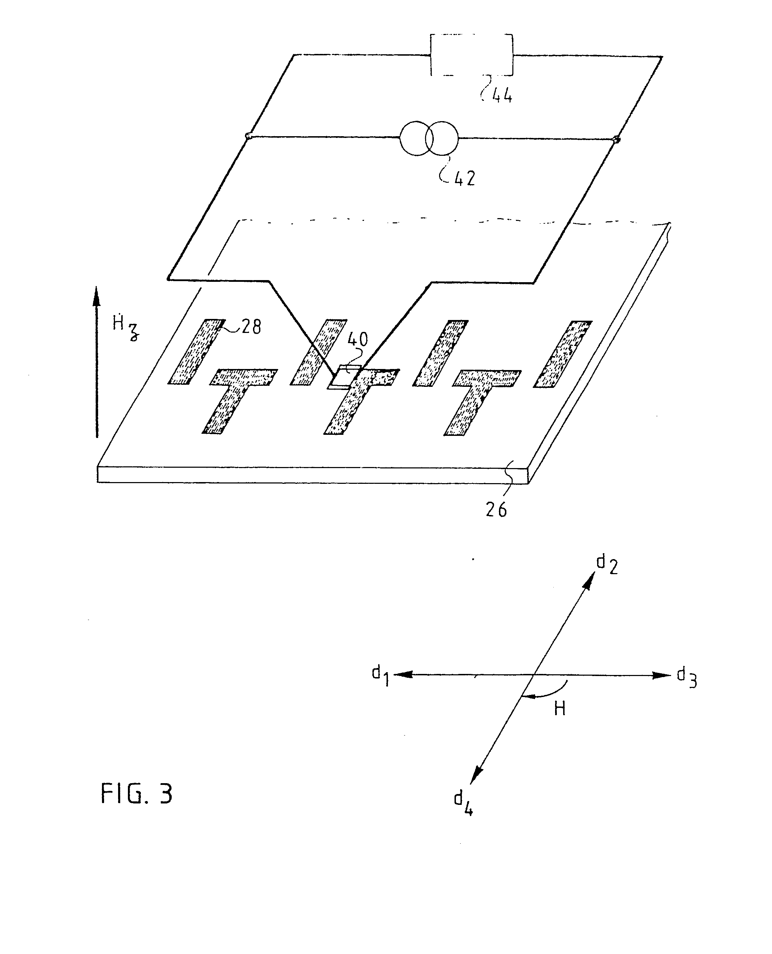

A titre purement illustratif, la figure 3 représente une
mémoire équipée d'un chemin de propagation 28 qui est
constitué par une suite d'électrodes en forme de T et de
I, et par un élément de lecture 40 qui est disposé sur
ce chemin de propagation et qui est du type magnétorésistif, c'est-à-dire dont la résistance dépend du champ
magnétique qui lui est appliqué. Cet élément est relié
à une source de courant constant 42 et à un dispositif
44 de mesure de la tension apparaissant à ses bornes.
Sur la partie en bas à droite de la figure, apparaît
symboliquement un champ magnétique tournant H appliqué
dans le plan de la couche et dirigé alternativement selon quatre directions $d_1$, $d_2$, $d_3$ et $d_4$. Ce champ n'apparaît que lorsque la carte est introduite dans le poste

11

de commande, car c'est ce poste qui con... ... les moyens de création d'un tel champ. En dehors de cette situation, aucun champ tournant n'est appliqué à la couche, le seul champ présent étant le champ de polarisation Hz représenté sur la partie gauche de la figure.

Le fonctionnement détaillé des moyens illustrés sur la figure 3 ne sera pas donné ici car il est largement connu. On pourra se reporter à ce sujet aux documents cités plus haut. On peut indiquer sommairement, qu'en présence du champ tournant H, les bulles magnétiques sont attirées alternativement par les pôles apparaissant sur les électrodes du chemin de propagation. Elles cheminent ainsi sous les différentes électrodes. Le passage d'une bulle en regard de l'élément magnétorésistif 40 provoque une variation de l'induction dans laquelle baigne cet élément, ce qui entraîne une variation de sa résistance, donc une variation de la tension apparaissant à ses bornes (si le courant qui le traverse est constant). Le passage d'une bulle en regard de l'élément de détection se manifeste donc, en définitive, par une variation de la tension apparaissant sur l'appareil 44.

Le coupleur d'interface 4 dont est munie la carte de l'invention peut être quelconque et être constitué, par exemple par un connecteur à doigts métalliques, à aiguilles rétractables, ou à surface métallisées, etc... tous moyens qui assurent un contact électrique avec des moyens complémentaires situés dans le poste fixe.

Ce coupleur d'interface peut être aussi de caractère inductif et comprendre des spires en induction mutuelle avec d'autres spires disposées dans le poste de commande.

1

Revendications de brevet :

1. Carte portative, comprenant des moyens de traitement de l'information (4, 6, 8, 10, 20), caractérisée en ce qu'au moins une partie (6) de ces moyens est constituée par des éléments à bulles magnétiques.

2. Carte portative selon la revendication 1, caractérisée en ce que l'un au moins des éléments à bulles magnétiques (6) est une mémoire.

3. Carte portative selon l'une quelconque des revendications 1 et 2, caractérisée en ce que l'ensemble (6) des éléments à bulles magnétiques comprend une couche (26) de matériau magnétique apte à contenir des bulles magnétiques, cette couche étant munie d'un chemin de propagation (28) et d'un moyen (40) de détection des bulles, et des moyens (34, 36) de création d'un champ magnétique de polarisation perpendiculaire à ladite couche.

4. Carte portative selon la revendication 3, caractérisée en ce que les moyens de création (34, 36) du champ magnétique de polarisation sont constitués par deux aimants permanents plats disposés de part et d'autre de la couche.

5. Carte portative selon l'une quelconque des revendications 3 et 4, caractérisée en ce que le moyen de détection des bulles (40) est constitué par un élément magnétorésistif et par un moyen de détection (44) de la variation de tension aux bornes de la résistance de cet élément.

6. Carte portative selon l'une quelconque des revendications 1 à 5, caractérisée en ce que les moyens de

2

de traitement de l'information comprennent un comparateur (10) et un circuit de traitement (20), le comparateur possédant deux entrées (12, 14) et une sortie (16), la sortie du comparateur autorisant la mise en œuvre du circuit de traitement (20).

0013191

FIG.1

FIG.2

$H_z$

28

40

26

FIG. 3

$d_2$

$d_1$     $d_3$

H

$d_4$

44

42

0013191

Numéro de la demande

EP 79 40 0842

**Office européen
des brevets**

# RAPPORT DE RECHERCHE EUROPEENNE

| Catégorie | Citation du document avec indication, en cas de besoin, des parties pertinentes | Revendication concernée |
|---|---|---|
| A | US - A - 3 786 445 (HO)<br><br>* Ensemble du brevet *<br><br>---- | 1 |

**DOCUMENTS CONSIDERES COMME PERTINENTS**

**CLASSEMENT DE LA DEMANDE (Int. Cl. 3)**

G 06 K 19/06
G 11 C 19/08

**DOMAINES TECHNIQUES RECHERCHES (Int. Cl. 3)**

G 06 K 19/06
       7/08
G 11 C 19/08

**CATEGORIE DES DOCUMENTS CITES**

X: particulièrement pertinent

A: arrière-plan technologique

O: divulgation non-écrite

P: document intercalaire

T: théorie ou principe à la base de l'invention

E: demande faisant interférence

D: document cité dans la demande

L: document cité pour d'autres raisons

&: membre de la même famille, document correspondant

| ☒ | Le présent rapport de recherche a été établi pour toutes les revendications |
|---|---|

| Lieu de la recherche | Date d'achèvement de la recherche | Examinateur |
|---|---|---|
| La Haye | 21-03-1980 | PESCHEL |

OEB Form 1503.1 06.78